# EUROPEAN PATENT SPECIFICATION

(11) **EP 2 530 741 B1**
(45) Date of publication and mention of the grant of the patent: **25.07.2018**
(21) Application number: 11734915.9
(22) Date of filing: 25.01.2011
(51) Int. Cl.: H01L 31/048

(54) **PHOTOVOLTAIC MODULE**
PV-MODUL
MODULE PHOTOVOLTAÏQUE

(30) Priority: 25.01.2011 KR 20110007452; 25.01.2010 KR 20100006697
(43) Date of publication of application: 05.12.2012
(73) Proprietor: LG Chem, Ltd., Youngdungpo-gu Seoul 150-721 (KR)
(72) Inventor: KO, Min Jin, 305-380, Daejeon (KR)
(74) Representative: Goddar, Heinz J.
(86) International application number: PCT/KR2011/000525
(87) International publication number: WO 2011/090366

(56) References cited:
- WO-A2-2007/120197
- JP-A- H0 964 391
- JP-A- 10 321 886
- JP-A- 2002 033 496
- JP-A- 2006 303 033
- JP-A- 2007 230 955
- KR-A- 20080 072 834
- US-A1- 2003 000 568

## Description

### [Technical Field]

The present invention relates to a photovoltaic module.

### [Background Art]

A photovoltaic cell or a solar cell is a cell capable of converting light energy into electric energy by using a photoelectric transformation element that is capable of generating photovoltaic power, when exposed to light. When the photovoltaic cell is exposed to light, it generates a voltage through terminals thereof and induces a flow of electrons. The magnitude of the electron flow is proportional to the collision strength of light on a photovoltaic cell junction formed on a cell surface.

Kinds of photovoltaic cells include a silicon wafer photovoltaic cell and a thin film photovoltaic cell. The silicon wafer photovoltaic cell includes a photoelectric transformation element prepared using a single crystal or polycrystalline silicon ingot, and a photoelectric transformation element used in the thin film photovoltaic cell is deposited on a substrate or a ferroelectric using a method such as sputtering or deposition.

Since the photovoltaic cell is brittle, it requires a support element for supporting the cells. The support element may be a light-transmissive front substrate arranged over a photoelectric transformation element. Also, the support element may be a back sheet arranged at the rear of the photoelectric transformation element. The photovoltaic cell may include both the light-transmissive front substrate and the back sheet. Generally, the front substrate or the back sheet may be made of rigid materials such as glass, flexible materials such as a metal film or sheet, or polymer plastic materials such as polyimides.

Generally, the back sheet is in the form of a rigid back skin to protect the rear surface of the photovoltaic cell. Various materials which may be applied to such a back sheet are known, and, for example, include a ferroelectric such as glass, an organic fluoropolymer such as ethylene tetrafluoroethylene (ETFE) or a polyester such as poly (ethylene terephthalate) (PET). Such materials may be applied alone or applied after being coated with a material such as SiOₓ.

The photovoltaic cell includes a photoelectric transformation element or photoelectric transformation elements that are electrically connected to each other, i.e. a photoelectric transformation element array. The photoelectric transformation element or the photoelectric transformation element array is encapsulated by an encapsulant. The encapsulant is used for encapsulation of the elements to protect them from external environments and used to form an integral module.

A conventionally used encapsulant is ethylene vinyl acetate (EVA). However, the EVA has low adhesive strength to other parts of the module. Therefore, if the EVA is used for a long period of time, delamination is readily induced, as well as lowered efficiency or corrosion due to moisture permeation is induced. Also, the EVA becomes discolored due to its low UV resistance and degrades the efficiency of the modules. Furthermore, the EVA has a problem of causing damage to the elements due to internal stress generated during curing processes.

WO2007/120197 A2 discloses a photovoltaic module that comprises a support substrate, a front substrate, and an encapsulant that encapsulates a photoelectric transformation element, the support substrate and the front substrate, and which comprises a silicone resin.

JP 0964391 A discloses a silicone resin into which a phenyl group has been introduced. A filler in which the difference in a refractive index between the silicone resin and itself is at 0.05 or lower is used.

JP 2007-230955 A discloses a rare earth metal complex having an organic carboxylic acid derivate having a graft-copolymerisable ethylenically unsaturated bond as a ligand.

### [Disclosure]

### [Technical Problem]

An object of the present invention is to provide a photovoltaic module.

### [Technical Solution]

The present invention relates to a photovoltaic module that comprises:
a support substrate;
a front substrate; and
an encapsulant that encapsulates a photoelectric transformation element between the support substrate and the front substrate, and that comprises a silicone resin which comprises an aryl group bound to a silicon atom and of which a molar ratio of the aryl group with respect to the total silicon atoms in the silicone resin is greater than 0.3
wherein the silicone resin is represented by an average composition formula of Formula 1:

   [Formula 1] (R₃SiO_{1/2})ₐ(R₂SiO_{2/2})_{b}(RSiO_{3/2})_{c}(SiO_{4/2})_{d}

   wherein R's are substituents directly bound to the silicon atoms, and independently represent hydrogen, a hydroxy group, an epoxy group, an acryloyl group, a methacryloyl group, an isocyanate group, an alkoxy group, an alkyl group, an alkenyl group or an aryl group, with the provision that at least one of the R's represents the aryl group; a is between 0 and 0.6, b is between 0 and 0.95, c is between 0 and 0.8, and d is between 0 and 0.4, with the provision that a+b+c+d is 1, wherein the silicone resin represented by the average composition formula of Formula 1 comprises a siloxane unit of the following Formula 6:

   [Formula 6] (C₆H₅)SiO_{3/2}.

Hereinafter, the photovoltaic module will be described in further detail.

The photovoltaic module includes the front substrate and the rear substrate, and also includes the photoelectric transformation element which is encapsulated by the encapsulant between the front substrate and the rear substrate. The encapsulant includes the silicone resin, particularly, the silicone resin that includes an aryl group bound to a silicon atom. In cases where the encapsulant encapsulating the photoelectric transformation element has a multi-layered structure of two or more layers, at least one of the layers, preferably all the layers, may include the silicone resin as described above.

The photoelectric transformation element may be any kinds of elements that are capable of converting light into an electric signal, and examples thereof may include a bulk type or thin film-type silicon photoelectric transformation element, a compound semiconductor photoelectric transformation element, and the like.

The silicon resin included in the encapsulant shows excellent adhesive strength with various parts and materials included in the module and which contact the encapsulant. Also the encapsulant shows excellent moisture resistance, weather resistance and lightfastness.

In one embodiment, an encapsulant that has excellent moisture resistance, weather resistance, adhesive strength and that also shows excellent light transmission efficiency to the photoelectric transformation element may be formed by using a silicon resin including an aryl group, specifically an aryl group bound to a silicon atom. Specific examples of the aryl group bound to a silicon atom are not particularly limited, but a phenyl group is preferred.

The silicone resin has a molar ratio (Ar/Si) of an aryl group (Ar) bound to a silicon atom with respect to the total silicon atoms (Si) in the silicone resin of greater than 0.3. Also, the molar ratio (Ar/Si) may preferably be greater than 0.5, and more preferably 0.7 or more. If the molar ratio (Ar/Si) is adjusted to be greater than 0.3, it is possible to maintain excellent moisture resistance, weather resistance and hardness of the encapsulant, as well as enhance electricity generation efficiency of the photovoltaic module. The upper limit of the molar ratio (Ar/Si) is not limited, but, for example, may be 1.5 or less or 1.2 or less.

The silicone resin is represented by an average composition formula of the following Formula 1.

[Formula 1] (R₃SiO_{1/2})ₐ(R₂SiO_{2/2})_{b}(RSiO_{3/2})_{c}(SiO_{4/2})_{d}

wherein R's are substituents that are directly bound to the silicon atoms, and independently represent hydrogen, a hydroxy group, an epoxy group, an acryloyl group, a methacryloyl group, an isocyanate group, an alkoxy group or a monovalent hydrocarbon group, with the provision that at least one of the R's represents an aryl group; a is between 0 and 0.6, b is between 0 and 0.95, c is between 0 and 0.8, and d is between 0 and 0.4, with the proviso that a+b+c+d is 1.

In this specification, a silicone resin being represented by a certain average composition formula means cases where the resin comprises a single resin component that is represented by the certain average composition formula as well as cases where the resin includes a mixture of at least two resin components, and an average composition of the at least two resin components is represented by the certain average composition formula.

In Formula 1, R's are substituents that are directly bound to a silicon atom, and the respective R's may be the same or different, and each independently represents hydrogen, a hydroxy group, an epoxy group, an acryloyl group, a methacryloyl group, an isocyanate group, an alkoxy group, vinyl group, or a monovalent hydrocarbon group. In this case, R's may be substituted with one or two or more substituents, if necessary.

In Formula 1, alkoxy may be linear, branched or cyclic alkoxy having 1 to 12 carbon atoms, preferably 1 to 8 carbon atoms, and more preferably 1 to 4 carbon atoms. Particularly, the alkoxy may include methoxy, ethoxy, propoxy, isopropoxy, butoxy, isobutoxy or tert-butoxy.

Also in Formula 1, the monovalent hydrocarbon group includes an alkyl group, an alkenyl group, or an aryl group.

In Formula 1, the alkyl group may be a linear, branched or cyclic alkyl group having 1 to 12 carbon atoms, preferably 1 to 8 carbon atoms, and more preferably 1 to 4 carbon atoms, and a methyl group may be preferred.

Also in Formula 1, the alkenyl group may be an alkenyl group having 2 to 12 carbon atoms, preferably 2 to 8 carbon atoms, and more preferably 2 to 4 carbon atoms, and a vinyl group may be preferred.

Also in Formula 1, the aryl group may be an aryl group having 6 to 18 carbon atoms, preferably 6 to 12 carbon atoms, and a phenyl group may be preferred.

In Formula 1, at least one of the R's may be an aryl group, preferably a phenyl group, and substituents may be included in the silicone resin to meet the above-mentioned molar ratio (Ar/Si).

Also in Formula 1, at least one of the R's may preferably be a hydroxy group, an epoxy group, an acryloyl group, a methacryloyl group or a vinyl group, and more preferably an epoxy group. Such a functional group may act to further improve adhesive strength of the encapsulant.

In Formula 1, a, b, c and d represent mole fractions of the siloxane units, respectively, and the total sum of a, b, c and d is 1. Also in Formula 1, a may be between 0 and 0.6, preferably between 0 and 0.5, b may be between 0 and 0.95, preferably between 0 and 0.8, c may be between 0 and 0.8, preferably between 0 and 0.7, and d is between 0 and 0.4, preferably between 0 and 0.2, with the proviso that b and c are not 0 simultaneously.

The silicone resin may preferably include one selected from the group consisting of siloxane units represented by the following Formula 2.

[Formula 2] R¹R²SiO_{2/2}

wherein R¹ and R² each independently represent an alkyl group or an aryl group, with the provision that at least one of R¹ and R² is an aryl group; and R represents an aryl group.

The siloxane unit of Formula 2 may be a siloxane unit that includes at least one aryl group bound to a silicon atom. In this case, the aryl group may preferably be a phenyl group. Also, the alkyl group in the siloxane unit of Formula 2 may preferably be a methyl group.

The siloxane unit of Formula 2 may be at least one unit selected from siloxane units of the following Formulas 4 and 5.

[Formula 4] (C₆H₅)(CH₃)SiO_{2/2}

[Formula 5] (C₆H₅)₂SiO_{2/2}

In the silicone resin, the aryl groups bound to all the silicon atoms in the silicone resin are preferably included in the siloxane unit of Formula 2. In this case, the siloxane unit of Formula 2 is preferably the siloxane unit of Formula 4 or 5, and the siloxane unit of Formula 3 is preferably the siloxane unit of Formula 6.

In one embodiment, the silicon resin may have a molecular weight of 500 to 100,000, preferably 1,000 to 100,000. If the molecular weight of the resin is adjusted to the above range, the encapsulant may have excellent hardness and may also show excellent processability. In this specification, unless stated herein otherwise, the term "molecular weight" refers to a weight average molecular weight (M_{w}). Also, a weight average molecular weight refers to a value converted with respect to standard polystyrene and may be measured by gel permeation chromatography (GPC).

In one embodiment, the silicone resin may be any one of silicone resins represented by the following Formulas 7 to 20, but not limited thereto.

[Formula 7] (ViMe₂SiO_{1/2})₂(MePhSiO_{2/2})₃₀

[Formula 8] (ViMe₂SiO_{1/2})₂(Ph₂SiO_{2/2})₁₀(Me₂SiO_{2/2})₁₀

[Formula 9] (ViMe₂SiO)_{1/2})₂(Ph₂SiO_{2/2})₁₅(Me₂SiO_{2/2})₁₅(MeEpSiO_{2/2})₅

[Formula 10] (ViMe₂SiO_{1/2})₃(PhSiO_{3/2})₁₀

[Formula 11] (ViMe₂SiO_{1/2})₃(PhSiO_{3/2})₁₀(MeSiO_{3/2})₂

[Formula 12] (ViMe₂SiO_{1/2})₃(PhSiO_{3/2})₁₀(MeEpSiO_{2/2})₅

[Formula 13] (HMe₂SiO_{1/2})₃(PhSiO_{3/2})₁₀

[Formula 14] (ViMe₂SiO_{1/2})₂(EpSiO_{3/2})₃(MePhSiO_{2/2})₂₀

[Formula 15] (HMe₂SiO_{1/2})₃(PhSiO_{3/2})₁₀(MeEpSiO_{2/2})₅

[Formula 16] (HMe₂SiO_{1/2})₂(Ph₂SiO_{2/2})_{1.5}

[Formula 17] (PhSiO_{3/2})₁₀(MePhSiO_{2/2})₁₀(Me₂SiO_{2/2})₁₀

[Formula 18] (PhSiO_{3/2})₅(EpMeSiO_{2/2})₂(Me₂SiO_{2/2})₁₀

[Formula 19] (PhSiO_{3/2})₅(AcSiO_{3/2})₅(MePhSiO_{2/2})₁₀

[Formula 20] (PhSiO_{3/2})₁₀(AcSiO_{3/2})₅(ViMe2SiO_{1/2})₅

In Formulas 7 to 20, "Me" represents a methyl group, "Ph" represents a phenyl group, "Ac" represents an acryloyl group, and "Ep" represents an epoxy group.

Such a silicon resin may be prepared by various methods known in the art. For example, the silicon resin may be prepared, for example, using an addition-curable silicon material, a condensation-curable or polycondensation-curable silicon material, a UV-curable silicon material or a peroxide-vulcanized silicon material, and preferably prepared using an addition-curable silicon material, a condensation-curable or polycondensation-curable silicon material or a UV-curable silicon material.

The addition-curable silicon material may be cured by hydrosilylation. This material includes at least an organic silicon compound having at least one hydrogen atom directly bound to a silicon atom and an organic silicon compound having at least one unsaturated aliphatic group such as a vinyl group. The organic silicon compounds react with each other to be cured in the presence of a catalyst. Examples of the catalyst may include metals of Group VIII in the Periodic Table; catalysts in which the metals are supported in a support such as alumina, silica or carbon black; or salts or complexes of the metals. The metals of Group VIII which may be used herein include platinum, rhodium or ruthenium, platinum being preferred.

A method using the condensation-curable or polycondensation-curable silicon material includes preparing a silicon resin by means of hydrolysis and condensation of a silicon compound or a hydrolysate thereof, such as silane or siloxane, which has a hydrolyzable functional group such as a halogen atom or an alkoxy group. A unit compound usable in this method may include a silane compound such as R^{a}₃Si(OR^{b}), R^{a}₂Si(OR^{b})₂, R^{a}Si(OR^{b})₃ and Si(OR^{b})₄. In the silane compound, (OR^{b}) may represent a linear or branched alkoxy group having 1 to 8 carbon atoms, and more particularly, may be methoxy, ethoxy, n-propoxy, n-butoxy, isopropoxy, isobutoxy, sec-butoxy or t-butoxy. Also in the silane compound, R^{a} is a functional group bound to a silicon atom, and may be selected in consideration of substituents in a desired silicon resin.

A method using the UV-curable silicon material includes subjecting a silicon compound or a hydrolysate thereof, such as silane or siloxane having a UV-reactive group such as an acryloyl group, to hydrolysis and condensation to prepare a resin, and then preparing the desired resin by UV irradiation to the silicon resin.

The addition-curable, condensation-curable or polycondensation-curable, or UV-curable silicon materials are widely known in the art, and a desired resin may be readily prepared using the materials known to a person skilled in the art, according to a desired silicon resin.

In one embodiment, the encapsulant may further include a photo transformation material along with the silicone resin. The photo transformation material may absorb light having wavelengths in UV (ultraviolet) ranges among light that enters therein, may convert the absorbed light into light having wavelengths in visible or near-infrared ranges, and then may emit the converted light. Therefore, if the encapsulant includes such a photo transformation material, it is possible to maximize electricity generation efficiency of the photovoltaic module. In particular, in the encapsulant, the silicone resin does not absorb light in UV wavelengths, and therefore makes it possible to maximize an effect of using the photo transformation material.

The photo transformation material usable herein may include any materials that are able to absorb light having wavelengths in UV ranges and then emit light having wavelengths in visible or near-infrared ranges, but is not particularly limited thereto.

In one embodiment, the photo transformation material may be represented by the following Formula 21:

[Formula 21] Eu_{w}YₓO_{y}S_{z}

wherein w is between 0.01 and 0.2, x is between 2 and 3, y is between 2 and 3, and z is between 0 and 1.

In the encapsulant, the photo transformation material may be included in an amount of 0.1 parts by weight to 10 parts by weight, preferably 0.1 parts by weight to 5 parts by weight, and more preferably 0.2 parts by weight to 5 parts by weight, relative to 100 parts by weight of the silicone resin. If the amounts of the photo transformation material are adjusted within this range, it is possible to prevent photonic efficiency from being lowered due to light diffusion and to maximize photo transformation effect. Throughout this specification, the term "parts by weight" refers to a weight ratio, unless stated herein otherwise.

The encapsulant may further include any known components such as fillers in addition to the silicone resin and the photo transformation material.

The photovoltaic module may be formed in various shapes.

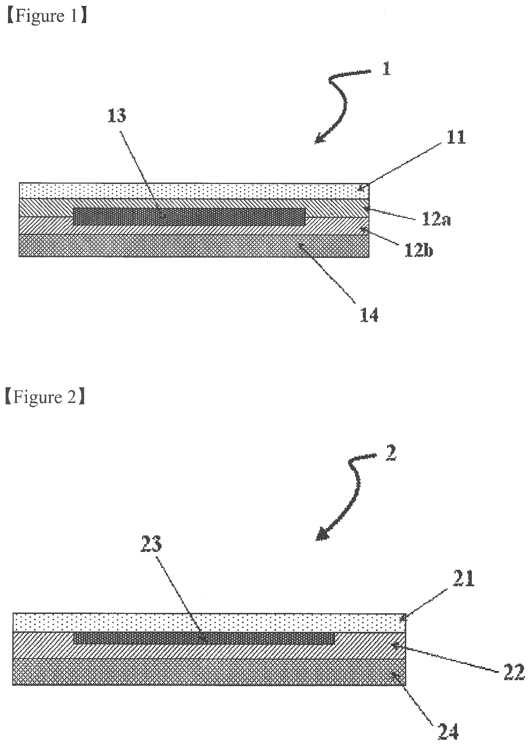

Figs. 1 and 2 are schematic diagrams showing an exemplary photovoltaic module.

Fig. 1 shows a photovoltaic module (1) including a wafer element as a photoelectric transformation element according to one embodiment. The photovoltaic module shown in Fig. 1 may generally include a front substrate (11) made of a ferroelectric such as glass; a back sheet (14) which may be Tedlar or a laminated sheet of PET/SiOx-PET/Al; a silicon wafer photoelectric transformation element (13); and encapsulants (12a and 12b) encapsulating the photoelectric transformation element (13). In this case, the encapsulant may include an upper encapsulant layer (12a) which is attached to the front substrate (11) in order to encapsulate the photoelectric transformation element (13) and a lower encapsulant layer (12b), which is attached to the support substrate (14) in order to encapsulate the photoelectric transformation element (13). In this case, one of the upper and lower encapsulant layers (12a and 12b) may include the components as described above; however, preferably both the upper and lower encapsulant layers (12a and 12b) may include the components as described above.

Fig. 2 is a schematic view of a thin film photovoltaic module (2) according to another embodiment. As shown in Fig. 2, in the thin film photovoltaic module (2), the photoelectric transformation element (23) may be formed on the front substrate (21) by, for example, a deposition method.

In the present invention, methods to prepare various photovoltaic modules as described above are not particularly limited, and various methods known in the art may be suitably applied.

For example, a photovoltaic module may be prepared by preparing an encapsulating sheet by the components included in the encapsulant, and then subjecting the sheet to a lamination method so as to prepare the module. For example, a photovoltaic module may be prepared by laminating the front substrate, the photoelectric transformation element, the back sheet and the encapsulating sheet according to the desired structure of the module, and then heating and pressing the laminate.

As another method, the photovoltaic module may be prepared by a method including coating a liquefied silicon resin composition including the photo transformation material around the photoelectric transformation element, and then curing the coated composition so as to form the encapsulant. In this case, the silicon resin composition may include a silicon resin represented by the average composition formula of Formula 1 as described above, or an addition-curable, condensation-curable or polycondensation-curable or UV-curable silicon material which may form the silicon resin.

### [Advantageous Effects]

The encapsulant in the photovoltaic cell has excellent moisture resistance, weather resistance, lightfastness and also shows excellent adhesive strength to other parts of the photovoltaic cell. Also, the encapsulant may act to effectively transmit incident light to a photoelectric transformation element and convert the incident light into light of wavelengths which is suitable for use in the photoelectric transformation element. Therefore, a photovoltaic cell having excellent durability and electricity generation efficiency may be provided.

### [Description of Drawings]

FIGS. 1 and 2 show exemplary photovoltaic modules in which
1: a wafer photovoltaic module
2: a thin film photovoltaic module
11, 21: front substrates
12a, 12b, 22: encapsulant sheets
13, 23: photoelectric transformation elements
14, 24: back sheets.

### [Best Mode]

Hereinafter, the present invention will be described in further detail referring to Examples according to the present invention and Comparative Examples that are not according to the present invention; however, the present invention is not limited to Examples.

In Examples and Comparative Examples, the symbol "Vi" represents a vinyl group, the symbol "Me" represents a methyl group, the symbol "Ph" represents a phenyl group, and the symbol "Ep" represents an epoxy group.

### Example 1

### Preparation of Composition (A) for Encapsulant

The organosiloxane compounds which were synthesized by a known method and which were represented by the following Formulas A, B, C and D respectively were mixed so as to prepare a siloxane composition capable of being cured by hydrosilylation (Mixing amounts: Compound A 100g, Compound B 10g, Compound C 200g and Compound D 60g). Then, a catalyst (platinum(0)-1,3-divinyl-1,1,3,3-tetramethyldisiloxane) was blended at such an amount that the content of Pt(0) in the siloxane composition was 20 ppm, and homogeneously mixed to prepare resin composition (A).

[Formula A] (ViMe₂SiO_{1/2})₂(Ph₂SiO_{2/2})₁₀(Me₂SiO_{2/2})₁₀

[Formula B] (ViMe₂SiO_{1/2})₂(EPSiO_{3/2})₃(MePhSiO_{2/2})₁₅

[Formula C] (ViMe₂SiO_{1/2})₃(MePhSiO_{2/2})₁(PhSiO_{3/2})₉

[Formula D] (HMe₂SiO_{1/2})₂(Ph₂SiO_{2/2})_{1.5}

### Preparation of Photovoltaic Module

The composition (A) for an encapsulant was coated onto a glass substrate for a photovoltaic module, and then cured at 100 °C for 1 hour. Subsequently, a photoelectric transformation element was placed on the cured composition, and the composition (A) for an encapsulant was coated onto the photoelectric transformation element. Then, the coated composition (A) was cured at 150 °C for 1 hour, and then a back sheet was heat pressed to prepare a photovoltaic module.

### Comparative Example 1

### Preparation of Composition (B) for Encapsulant

The organosiloxane compounds which were synthesized using a known method, and which were represented by the following Formulas E to G were mixed together to prepare a siloxane composition capable of being cured by hydrosilylation (Mixing amounts: Compound E 100g, Compound F 20g, and Compound G 50g). Then, a catalyst (platinum(0)-1,3-divinyl-1,1,3,3-tetramethyldisiloxane) (at such an amount that the content of Pt(0) in the siloxane composition was 10 ppm) was mixed with the siloxane composition, and then homogeneously mixed to prepare resin composition (B).

[Formula E] (ViMe₂SiO_{1/2})₂(ViMeSiO_{2/2})₁₅(MeSiO_{3/2})₅(Me₂SiO_{2/2})₅₀

[Formula F] (ViMe₂SiO_{1/2})₂(MeSiO_{3/2})₆

[Formula G] (HMe₂SiO_{1/2})₂(HMeSiO_{2/2})₂(Me₂SiO_{2/2})₁₀

### Preparation of Photovoltaic Module

The resin composition (B) for an encapsulant was coated onto the same glass substrate used in Example 1 for a photovoltaic module, and then cured at 100 °C for 1 hour. Subsequently, the same photoelectric transformation element as used in Example 1 was placed on the cured resin composition, and resin composition (B) for an encapsulant was coated onto the photoelectric transformation element. Then, the coated resin composition (B) was cured at 150 °C for 1 hour, and then the same back sheet used in Example 1 was heat pressed to prepare a photovoltaic module.

### Comparative Example 2

### Preparation of Composition (C) for Encapsulant

The organosiloxane compounds which were synthesized using a known method, and which were represented by the following Formulas H to J were mixed together to prepare a siloxane composition capable of being cured by hydrosilylation (Mixing amounts: Compound H 100g, Compound I 20g and Compound J 50g). Then, a catalyst (platinum(0)-1,3-divinyl-1,1,3,3-tetramethyldisiloxane) was mixed at such an amount that the content of Pt(0) in the siloxane composition was 20 ppm, and then homogeneously mixed to prepare resin composition (C).

[Formula H] (ViPh₂SiO_{1/2})₂(Me₂SiO_{2/2})₂₀

[Formula I] (ViPh₂SiO_{1/2})₃(MeSiO_{3/2})₁₀

[Formula J] (HMe₂SiO_{1/2})₂(HMeSiO_{2/2})₂(Me₂SiO_{2/2})₁₀

### Preparation of Photovoltaic Module

The resin composition (C) for an encapsulant was coated onto the same glass substrate as used in Example 1 for a photovoltaic module, and then cured at 100 °C for 1 hour. Subsequently, the same photoelectric transformation element as used in Example 1 was placed on the cured resin composition, and the resin composition (C) for an encapsulant was coated onto the photoelectric transformation element. Then, the coated resin composition (C) was cured at 150 °C for 1 hour, and the same back sheet as used in Example 1 was pressed to prepare a photovoltaic module.

### Comparative Example 3

A photovoltaic module was prepared in the same manner as described in Example 1, except that an EVA sheet for an encapsulant, which has been typically used as the encapsulant for a photovoltaic module, was used instead of composition (A) for an encapsulant prepared in Example 1, in order to encapsulate a photoelectric transformation element.

### 1. Evaluation of Power Generation of Photovoltaic Module

Efficiencies of the photovoltaic modules prepared in Example and Comparative Examples were evaluated using a sum simulator. More particularly, glass substrates of the photovoltaic modules were irradiated with a light source of approximately 1 kW for the same period of time, and electricity generation capacities of the photovoltaic modules were measured. The measurement results are summarized and listed in the following Table 1.

**[Table 1]**

| | Example 1 | Comparative Example 1 | Comparative Example 2 | Comparative Example 3 |
|---|---|---|---|---|
| Power Generation Efficiency | 9.5% | 9.3% | 9.0% | 9.2% |

### 2. Moisture Permeability. Durability/Reliability and Yellowing Preventing Effect

### (1) Measurement of Moisture Permeability

Composition (A) of Example 1, composition (B) of Comparative Example 1, and composition (C) of Comparative Example 2 were cured at 150 °C for 1 hour respectively, so as to prepare 1 mm-thick planar test samples, and also a sheet for an EVA encapsulant used in Comparative Example 3 was used to prepare a 1 mm-thick planar test sample. Then, the prepared planar test samples were measured for moisture permeability. Moisture permeability of the planar test samples was measured in a thickness direction in the same conditions using a Mocon tester, and the results are listed in the following Table 2.

### (2) Measurement of Reliability under High-temperature and High-moisture Conditions

Composition (A) of Example 1, composition (B) of Comparative Example 1, and composition (C) of Comparative Example 2 were coated at the same thickness on glass substrates, cured and then kept at a temperature of 85 °C and relative moisture of 85% for 500 hours. Then, peel strengths of cured products of the compositions with respect to the glass substrates were evaluated by a peel test, and values of the peel strengths were evaluated according to the following criteria, thereby evaluating reliability of the cured products under high-temperature and high-moisture conditions.

### <Evaluation Criteria>

○: Peel strength with respect to a glass substrate is similar to or greater than 15 gf/mm
×: Peel strength with respect to a glass substrate is less than 15 gf/mm

### (3) Measurement of Yellowing Level

Each test sample used to measure the moisture permeability was illuminated with light at 60 °C for 3 days using a Q-UVA (340 nm, 0.89 W/Cm²) tester, and evaluated for yellowing according to the following criteria. The results are described, as follows.

### <Evaluation Criteria>

○: Absorbance of light having 450 nm wavelength is less than 5%
×: Absorbance of light having 450 nm wavelength is more than 5%

**[Table 2]**

| | **Example 1 (Composition (A))** | **Comparative Example 1 (Composition (B))** | **Comparative Example 2 (Composition (C))** | **Comparative Example 3 (EVA)** |
|---|---|---|---|---|
| Moisture Permeability | 15 g/cm²/day | 105 g/cm²/day | 120 g/cm²/day | 10 g/cm²/day |
| Durability/Reliability | ○ | × | × | - |
| Yellowing | ○ | ○ | ○ | × |

## Claims

1. A photovoltaic module that comprises:
a support substrate;
a front substrate; and
an encapsulant that encapsulates a photoelectric transformation element between the support substrate and the front substrate, and that comprises a silicone resin which comprises an aryl group bound to a silicon atom and of which a molar ratio of the aryl group with respect to the total silicon atoms in the silicone resin is greater than 0.3
wherein the silicone resin is represented by an average composition formula of Formula 1:
[Formula 1] (R₃SiO_{1/2})ₐ(R₂SiO_{2/2})_{b}(RSiO_{3/2})_{c}(SiO_{4/2})_{d}
wherein R's are substituents directly bound to the silicon atoms, and independently represent hydrogen, a hydroxy group, an epoxy group, an acryloyl group, a methacryloyl group, an isocyanate group, an alkoxy group, an alkyl group, an alkenyl group or an aryl group, with the provision that at least one of the R's represents the aryl group; a is between 0 and 0.6, b is between 0 and 0.95, c is between 0 and 0.8, and d is between 0 and 0.4, with the provision that a+b+c+d is 1, wherein the silicone resin represented by the average composition formula of Formula 1 comprises a siloxane unit of the following Formula 6:
[Formula 6] (C₆H₅)SiO_{3/2}.

2. The photovoltaic module according to claim 1, wherein a molar ratio of the aryl group that is bound to a silicon atom with respect to the total silicon atoms included in the silicon resin is greater than 0.5.

3. The photovoltaic module according to claim 1, wherein a molar ratio of the aryl group that is bound to a silicon atom with respect to the total silicon atoms included in the silicon resin is greater than 0.7.

4. The photovoltaic module according to claim 1, wherein the aryl group in the silicone resin is a phenyl group.

5. The photovoltaic module according to claim 1, wherein the at least one of R's is a hydroxy group, an epoxy group, an acryloyl group, a methacryloyl group or a vinyl group.

6. The photovoltaic module according to claim 1, wherein the at least one of the R's is an epoxy group.

7. The photovoltaic module according to claim 1, wherein the silicone resin represented by the average composition formula of Formula 1 comprises a siloxane unit of the following Formula 2:
[Formula 2] R¹R²SiO_{2/2}
wherein R¹ and R² each independently represent an alkyl group or an aryl group, with the provision that at least one of R¹ and R² represents an aryl group.

8. The photovoltaic module according to claim 7, wherein the siloxane unit of Formula 2 is at least one selected from the group consisting of siloxane units of the following Formulas 4 and 5:
[Formula 4] (C₆H₅)CH₃SiO_{2/2}
[Formula 5] (C₆H₅)₂SiO_{2/2}.

9. The photovoltaic module according to claim 1, wherein the silicone resin has a weight average molecular weight of 500 to 100,000, wherein the weight average molecular weight refers to a value converted with respect to standard polystyrene measured by gel permeation chromatography (GPC).

10. The photovoltaic module according to claim 1, wherein the encapsulant further comprises a photo transformation material.

11. The photovoltaic module according to claim 10, wherein the photo transformation material is represented by the following Formula 21:
[Formula 21] Eu_{w}YₓO_{y}S_{z}
wherein w is between 0.01 and 0.2, x is between 2 and 3, y is between 2 and 3, and z is between 0 and 1.

12. The photovoltaic module according to claim 10, wherein the encapsulant includes 0.1 parts by weight to 10 parts by weight of the photo transformation material, relative to 100 parts by weight of the silicone resin.

## Patentansprüche

1. Photovoltaikmodul, welches umfasst:
ein Trägersubstrat;
ein Frontsubstrat; und
ein Einkapselungsmittel, das ein photoelektrisches Transformationselement zwischen dem Trägersubstrat und dem Frontsubstrat einkapselt, und das ein Siliconharz umfasst, das eine Arylgruppe gebunden an ein Siliziumatom umfasst, und dessen Molverhältnis der Arylgruppe in Bezug auf die gesamten Siliziumatome in dem Siliconharz größer als 0,3 ist,
wobei das Siliconharz durch eine durchschnittliche Zusammensetzungsformel der Formel 1 dargestellt wird:
[Formel 1] (R₃SiO_{1/2})ₐ(R₂SiO_{2/2})_{b}(RSiO_{3/2})_{c}(SiO_{4/2})_{d},
wobei R Substituenten sind, die direkt an die Siliziumatome gebunden sind und unabhängig Wasserstoff, eine Hydroxygruppe, eine Epoxygruppe, eine Acryloylgruppe, eine Methacryloylgruppe, eine Isocyanatgruppe, eine Alkoxygruppe, eine Alkylgruppe, eine Alkenylgruppe oder eine Arylgruppe darstellen, mit der Maßgabe, dass wenigstens eines der R die Arylgruppe darstellt; a zwischen o und 0,6 ist, b zwischen o und 0,95 ist, c zwischen o und 0,8 ist und d zwischen o und 0,4 ist, mit der Maßgabe, dass a+b+c+d 1 ist, wobei das durch die durchschnittliche Zusammensetzungsformel der Formel 1 dargestellte Siliconharz eine Siloxaneinheit der folgenden Formel 6 umfasst:
[Formel 6] (C₆H₅)SiO_{3/2}.

2. Photovoltaikmodul nach Anspruch 1, wobei ein Molverhältnis der Arylgruppe, die an ein Siliziumatom gebunden ist, in Bezug auf die gesamten Siliziumatome, die in dem Silikonharz eingeschlossen sind, größer als 0,5 ist.

3. Photovoltaikmodul nach Anspruch 1, wobei ein Molverhältnis der Arylgruppe, die an ein Siliziumatom gebunden ist, in Bezug auf die gesamten Siliziumatome, die in dem Silikonharz eingeschlossen sind, größer als 0,7 ist.

4. Photovoltaikmodul nach Anspruch 1, wobei die Arylgruppe in dem Siliconharz eine Phenylgruppe ist.

5. Photovoltaikmodul nach Anspruch 1, wobei das wenigstens eine der R eine Hydroxygruppe, eine Epoxygruppe, eine Acryloylgruppe, eine Methacryloylgruppe oder eine Vinylgruppe ist.

6. Photovoltaikmodul nach Anspruch 1, wobei das wenigstens eine der R eine Epoxygruppe ist.

7. Photovoltaikmodul nach Anspruch 1, wobei das Siliconharz, das durch die durchschnittliche Zusammensetzungsformel der Formel 1 dargestellt ist, eine Siloxaneinheit der folgenden Formel 2 umfasst:
[Formel 2] R¹R²SiO_{2/2},
wobei R¹ und R² jeweils unabhängig eine Alkylgruppe oder eine Arylgruppe darstellen, mit der Maßgabe, dass wenigstens eines von R¹ und R² eine Arylgruppe darstellt.

8. Photovoltaikmodul nach Anspruch 7, wobei die Siloxaneinheit der Formel 2 wenigstens eine ist, die ausgewählt ist aus der Gruppe bestehend aus Siloxaneinheiten der folgenden Formeln 4 und 5:
[Formel 4] (C₆H₅)CH₃SiO_{2/2}
[Formel 5] (C₆H₅)₂SiO_{2/2}.

9. Photovoltaikmodul nach Anspruch 1, wobei das Siliconharz ein Gewichtsmittelmolekulargewicht von 500 bis 100.000 aufweist, wobei das Gewichtsmittelmolekulargewicht sich auf einen Wert bezieht, der in Bezug auf Standardpolystyrol, gemessen durch Gelpermeationschromatographie (GPC), umgewandelt ist.

10. Photovoltaikmodul nach Anspruch 1, wobei das Einkapselungsmittel ferner ein Phototransformationsmaterial umfasst.

11. Photovoltaikmodul nach Anspruch 10, wobei das Phototransformationsmaterial durch die folgende Formel 21 dargestellt ist:
[Formel 21] Eu_{w}YₓO_{y}S_{z},
wobei w zwischen 0,01 und 0,2 ist, x zwischen 2 und 3 ist, y zwischen 2 und 3 ist und z zwischen 0 und 1 ist.

12. Photovoltaikmodul nach Anspruch 10, wobei das Einkapselungsmittel 0,1 Gewichtsteile bis 10 Gewichtsteile des Phototransformationsmaterials, in Bezug auf 100 Gewichtsteile des Siliconharzes, einschließt.

## Revendications

1. Module photovoltaïque qui comprend :
un substrat de support ;
un substrat avant ; et
un encapsulant qui encapsule un élément de transformation photoélectrique situé entre le substrat de support et le substrat avant, et qui comprend une résine de silicone qui contient un groupe aryle lié à un atome de silicium et dont le rapport molaire du groupe aryle par rapport au nombre total d'atomes de silicone contenus dans la résine de silicone est supérieur à 0,3
dans lequel la résine de silicone est représentée par une formule de composition moyenne de la formule 1 :
[Formule 1] (R₃SiO_{1/2})ₐ(R₂SiO_{2/2})_{b}(RSiO_{3/2})_{c}(SiO_{4/2})_{d}
dans laquelle les R sont des substituants liés aux atomes de silicium, et représentent indépendamment l'hydrogène, un groupe hydroxy, un groupe époxy, un groupe acryloyle, un groupe méthacryloyle, un groupe isocyanate, un groupe alcoxy, un groupe alkyle, un groupe alcényle ou un groupe aryle, à la condition que au moins l'un des R représente le groupe aryle ; a est compris entre 0 et 0,6, b est compris entre 0 et 0,95, c est compris entre 0 et 0,8, et d est compris entre 0 et 0,4, à la condition que a+b+c+d est égal à 1, dans laquelle la résine de silicone représentée par la formule de composition moyenne de la formule 1 comprend un motif de siloxane de la formule 6 suivante :
[Formule 6] (C₆H₅)SiO_{3/2}.

2. Module photovoltaïque selon la revendication 1, dans lequel un rapport molaire du groupe aryle qui est lié à un atome de silicium par rapport au nombre total d'atomes de silicium contenus dans la résine de silicone est supérieur à 0,5.

3. Module photovoltaïque selon la revendication 1, dans lequel un rapport molaire du groupe aryle qui est lié à un atome de silicium par rapport au nombre total d'atomes de silicium contenus dans la résine de silicone est supérieur à 0,7.

4. Module photovoltaïque selon la revendication 1, dans lequel le groupe aryle contenu dans la résine de silicone est un groupe phényle.

5. Module photovoltaïque selon la revendication 1, dans lequel au moins un des R représente un groupe hydroxy, un groupe époxy, un groupe acryloyle, un groupe méthacryloyle ou un groupe vinyle.

6. Module photovoltaïque selon la revendication 1, dans lequel le au moins un des R représente un groupe époxy.

7. Module photovoltaïque selon la revendication 1, dans lequel la résine de silicone représentée par la formule de composition moyenne de la formule 1 comprend une unité de siloxane de la formule 2 suivante :
[Formule 2] R¹R²SiO_{2/2}
dans laquelle R¹ et R² représentent chacun indépendamment un groupe alkyle ou un groupe aryle, à la condition qu'au moins l'un de R¹ et de R² représente un groupe aryle.

8. Module photovoltaïque selon la revendication 7, dans lequel le motif de siloxane de la formule 2 est au moins un motif sélectionné dans le groupe constitué de motifs de siloxane des formules 4 et 5 suivantes :
[Formule 4] (C₆H₅)CH₃SiO_{2/2}
[Formule 5] (C₆H₅)2SiO_{2/2}.

9. Module photovoltaïque selon la revendication 1, dans lequel la résine de silicone a un poids moléculaire moyen en poids de 500 à 100.000, dans lequel le poids moléculaire moyen en poids se réfère à une valeur convertie par rapport au polystyrène normalisé mesuré par chromatographie par perméation de gel.

10. Module photovoltaïque selon la revendication 1, dans lequel l'encapsulant comprend en outre un matériau de photo-transformation.

11. Module photovoltaïque selon la revendication 10, dans lequel le matériau de photo-transformation est représenté par la formule 21 suivante :
[Formule 21] Eu_{w}YₓO_{y}S_{z}
dans laquelle w est compris entre 0,01 et 0,2, x est compris entre 2 et 3, y est compris entre 2 et 3 et z est compris entre 0 et 1.

12. Module photovoltaïque selon la revendication 10, dans lequel l'encapsulant contient 0,1 parties en poids à 10 parties en poids du matériau de photo-transformation par rapport à 100 partes en poids de la résine de silicone.
